# EUROPEAN PATENT APPLICATION

(11) **EP 1 467 252 A1**
(43) Date of publication of application: **13.10.2004**
(21) Application number: 03252181.7
(22) Date of filing: 07.04.2003
(51) Int. Cl.: G03F 7/20

(54) **Device manufacturing method and mask set for use in the method**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

Isolated dark features, *e.g.* contact holes or lines, are exposed in a double exposure, using for example a box-in-box pattern (Fig.2C and Fig.2D), and using different illumination settings in the two exposures.

## Description

The present invention relates to a device manufacturing method using lithographic projection apparatus comprising:
- a radiation system for supplying a projection beam of radiation;
- a support structure for supporting patterning means, the patterning means serving to pattern the projection beam according to a desired pattern;
- a substrate table for holding a substrate; and
- a projection system for projecting the patterned beam onto a target portion of the substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.
For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

When imaging isolated features such as lines and contact holes, the achievable depth of focus (DOF) is generally small and therefore various techniques for improving DOF when imaging such features have been developed. For isolated lines, various forms of assist features have been proposed but the size of assist features must be limited to avoid the printing of unwanted residues. Hence the extent to which such features can improve DOF is limited. For contact holes, the use of attenuated phase shift masks and three tone masks has been proposed but these methods still do not result in a particularly large DOF.

"Innovative Imaging of Ultra-fine Line without Using Any Strong RET" by Shuji Nakao *et al,* Optical Microlithography XIV Proceedings of SPIE Vol 4346 (2001) discloses a technique in which a sub-100nm line pattern is imaged in two exposures. First the dark line is imaged between two bright lines then a second exposure erases the unwanted dark lines between the pairs of bright lines so that the dark lines are isolated in a bright field. Conventional illumination is used so that other large structures can be imaged at the same time.

It is an object of the present invention to provide a method of manufacturing devices in which isolated features, particularly dark features on a bright background, are imaged with increased depth of focus, and also to provide masks for use in that method.

This and other objects are achieved according to the invention in a device manufacturing method comprising the steps of:
- providing a substrate that is at least partially covered by a layer of radiation-sensitive material;
- providing a projection beam of radiation using a radiation system;
- performing a first exposure by using patterning means to endow the projection beam with a first pattern in its cross-section, said first pattern including a desired isolated dark feature in a bright local region and being dark around said bright local region; and projecting the patterned beam of radiation onto a target portion of the layer of radiation-sensitive material, and
- performing a second exposure by using patterning means to endow the projection beam with a second pattern in its cross-section, said second pattern being dark in a region corresponding to said bright local region and bright in a wider region around said local region; and projecting the patterned beam of radiation onto a target portion of the layer of radiation-sensitive material,
characterized in that:
first illumination settings are used in said first exposure and second illumination settings are used in said second exposure, said second illumination settings being at least partly different than said first illumination settings.

By optimizing the illumination settings for the two exposures separately, it is possible to maximize the DOF and exposure latitude for the isolated dark feature. In some cases, the illumination mode for the second exposure is preferably arranged so that substantially no light enters the dark region corresponding to the local bright region in the first exposure. In other cases, the out-of-focus behaviors of the first and second exposures can be arranged to cancel each other out so as to provide a combined depth of focus greater than the depths of focus of either exposure separately. Experiments or simulations can be used to determine which approach is most appropriate for a given pattern to be exposed.

Isolated features are, for example, features separated from their nearest neighbor by a distance greater than 3 times the relevant target feature dimension, *e.g.* line width or contact hole diameter. NB, the target feature dimension is the dimension of the feature in resist after development that is aimed at.

The illumination settings to be optimized for the two exposures may include the illumination mode - *e.g.* circular, annular, dipole, quadrupole, *etc.* - and parameters of the illumination mode - *e.g.* NA, *σ,* σᵢₙₙₑᵣ, σₒᵤₜₑᵣ, orientation of multipole modes, polarization, dose, focus, lens settings and exposure wavelength, *etc.*. It is also possible to create specific custom illumination distributions for the two exposures, *e.g.* using diffractive optical elements.

The present invention is particularly applicable to the formation of contact holes using a negative tone resist, in which case an improved depth of focus can be obtained if the first and second exposures employ a quadrupole illumination mode with poles on the diagonals but with the poles nearer the center of the pupil plane in the second exposure.

The present invention is also applicable to the formation of isolated lines in which case an improved depth of focus can be obtained if the first exposure uses a dipole illumination mode with the poles on the axis perpendicular to the isolated line and the second exposure uses a dipole illumination mode with the poles on the axis parallel to the isolated line. Especially good results are achieved where the half-width of the local region is in the range of from 1.5 to 5 times the target width of the isolated line.

The present invention also provides a mask set for use in the above method and embodying a first pattern including a desired isolated dark feature in a bright local region; and a second pattern that is dark in a region corresponding to said bright local region and light in a wider region around said local region.

The first and second patterns may be embodied in different regions of a single mask if the patterns to be exposed are less than half the size of the mask or may be embodied in separate masks.

Yet further, the present invention provides a data set for use in the above method and for controlling a programmable patterning means to effect a first pattern including a desired isolated dark feature in a bright local region; and a second pattern that is dark in a region corresponding to said bright local region and light in a wider region around said local region.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultra-violet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figures 2A-G illustrate the illumination modes and mask patterns used in a first method according to the invention together with graphs of Focus vs. position for the separate and combined exposures; and
Figures 3A-G are views similar to Figures 2A-G relating to a second method according to the invention.

In the Figures, corresponding reference symbols indicate corresponding parts.

### Lithographic Apparatus

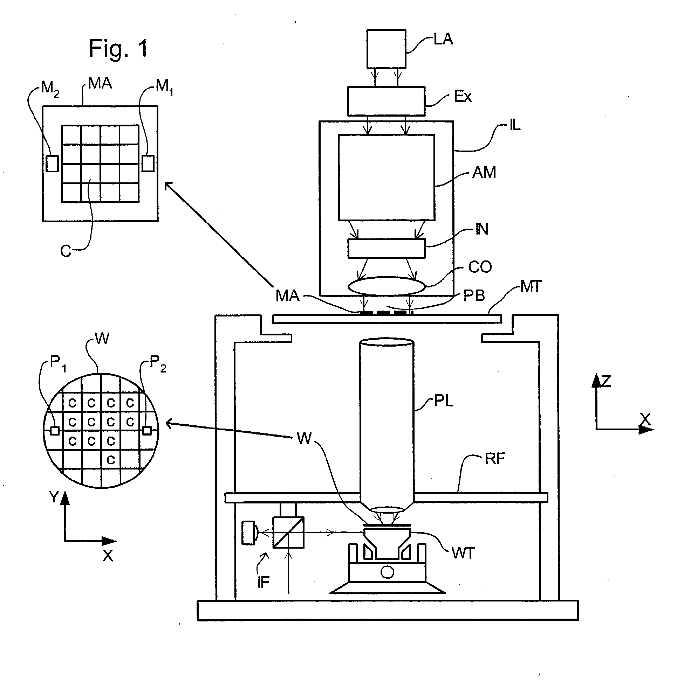

Figure 1 schematically depicts a lithographic projection apparatus which may be used in the methods of the invention. The apparatus comprises:
· a radiation system Ex, IL, for supplying a projection beam PB of radiation (*e.g.* DUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (*e.g.* a resist-coated silicon wafer), and connected to second positioning means for accurately positioning the substrate with respect to item PL;
· a projection system ("lens") PL (*e.g.* a refractive lens system) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed ν, so that the projection beam PB is caused to scan over a mask image; concurrently, the substrate table WT is simultaneously moved in the same or opposite direction at a speed *V* = *Mν*, in which *M* is the magnification of the lens PL (typically, *M =* 1/4 or 1/5). In this manner, a relatively large target portion C can be exposed, without having to compromise on resolution.

### Embodiment 1

In a first method of the invention, an isolated contact hole is printed using a negative resist. This is done in two exposures.

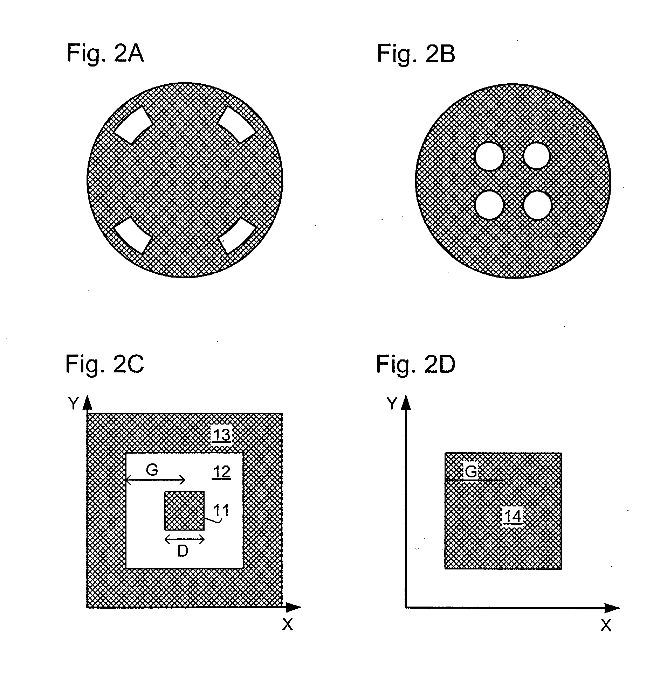

In a first exposure, a quadrupole illumination mode, shown schematically in Figure 2A, is used to illuminate a mask, the relevant part of which is shown in Figure 2C, which has an opaque region 11 corresponding to the contact hole surrounded by a local bright region 12. The bright region 12 is in turn surrounded by an opaque region 13 which extends to the locality of the neighboring features. The opaque region 11, corresponding to the contact hole, has a diameter D equal to the target diameter of the desired contact hole, *e.g.* 100nm, plus a bias value, *e.g.* in the range of from 0 to 60nm. The width G of the local bright region is set to be about two or three times the target diameter of the desired contact hole plus the bias value, *e.g.* 230 to 260nm.

NB dimensions given here and below are in "at substrate level" units so that the actual dimensions in the mask will be larger by a factor equal to the inverse of the magnification of the projection system PL, e.g. 4 to 5 times larger.

In the second exposure, a quadrupole illumination mode, shown schematically in Figure 2B, is also used, but with the poles closer to the origin of the pupil plane. This illuminates a pattern, part of which is shown in Figure 2D, which has an opaque region 14 corresponding to the bright region 12 in the first pattern and is bright elsewhere, save for dark regions (not shown) covering other structures exposed in the first exposure. It should be noted that the opaque region of the second exposure need not be exactly the same size as the local bright region in the first exposure. Some double exposure will have no detrimental effect and a small square may be left unexposed if the resulting structure will be washed away during development of the resist. In the case that the region 14 is larger than region 12, the difference should be less than half the target CD for the exposure. Where region 12 is larger than region 14, the isolated feature is less protected from the second exposure but that can be tolerated to a certain degree.

The first exposure is carried out at a NA optimum for imaging dense contact holes, e.g. = 0.71 for 100nm holes at a pitch of approximately 250nm, which accordingly may be imaged in the same step. Optimum values of D and G can be found by looking for the optimum exposure dose window.

The second exposure is carried out at illumination settings determined to have minimum disturbance at the center of the contact hole for all focus levels whilst simultaneously exposing the outer region. In the present example this criterion results in the use of a low NA setting, *e.g.* 0.5, and quadrupole settings optimized for the pitch of the second exposure structure. Hence the positions of the poles move towards the center of the pupil plane as compared to the settings for the first exposure.

The second exposure washes the outer regions, exposing the outer parts left unexposed by the first exposure. It also adds some energy in the out-of-focus region of the inner region, improving the through-focus behavior. This is because the first and second exposures have opposite out-of-focus behaviors.

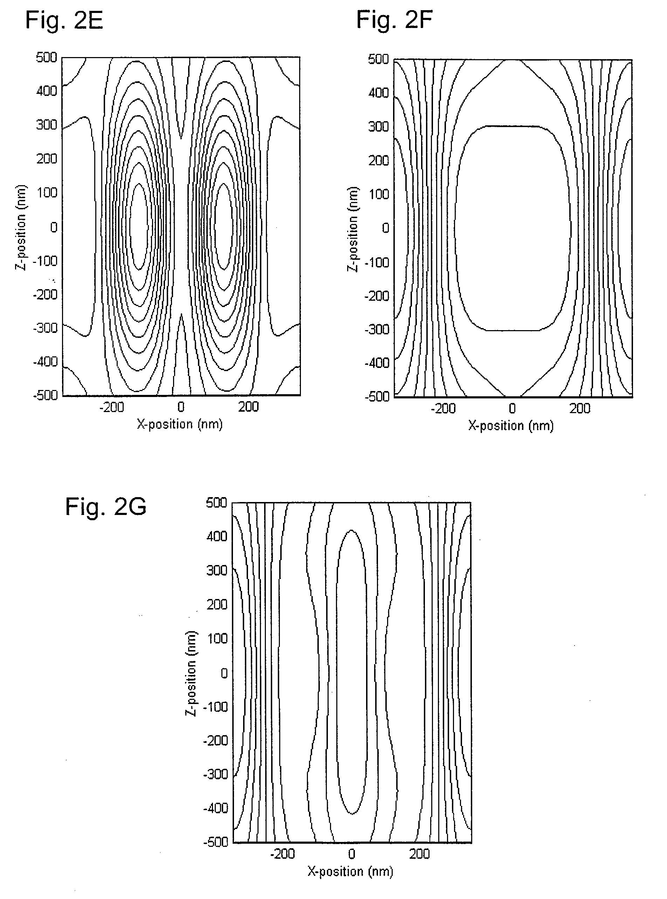

The effects of the first and second exposure are shown in Figures 2E and F respectively, which show the intensity of the aerial image in normalized units as a function of X position and Z (focus). Figure 2G is the sum of Figure 2E and F. It can be seen that the X distribution of the dose delivered is uniform for a wide range of Z values, indicating a large depth of focus.

### Embodiment 2

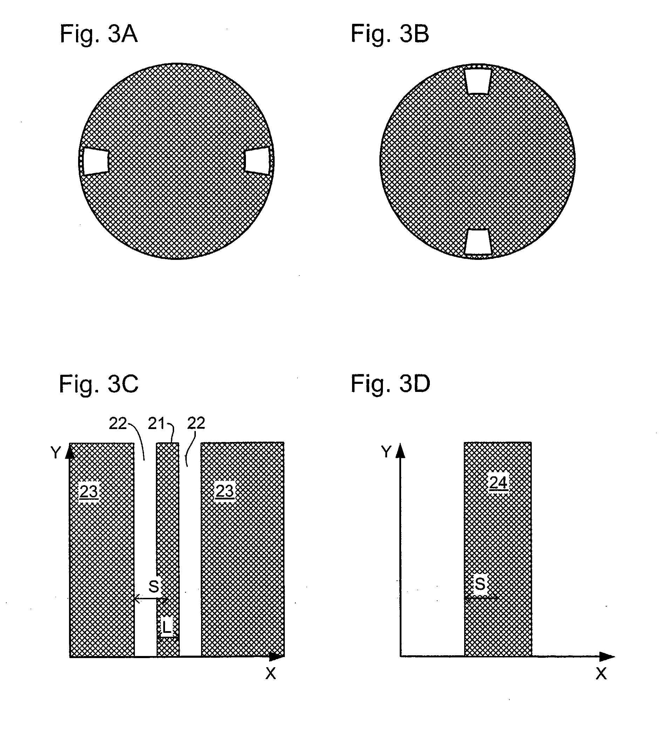

In a second method according to the invention, isolated lines are printed using two exposures. In a first exposure, a dipole illumination mode, shown schematically in Figure 3A, is used to illuminate a mask, the relevant part of which is shown in Figure 3C, which has an opaque region 21 corresponding to the isolated line surrounded by a local bright region 22. The poles of the dipole are arranged on the axis perpendicular to the line 21. The bright region 22 is in turn surrounded by an opaque region 23 which preferably extends to the locality of the neighboring features. Opaque region 23 should be as large as possible but improved results can be achieved with a smaller opaque region 23, *e.g.* extending for a distance of 2 or 3 times S. The opaque region 21, corresponding to the isolated line has a width L equal to the target width of the desired line, *e.g.* 75nm, in some cases plus a bias value. The halfwidth S of the local bright region is set to be in the range of from 1.5 to 2.5 times the full width of the line, e.g. about 230nm.

In the second exposure, a dipole illumination mode, shown schematically in Figure 3B, is again used, but with the poles on the axis parallel to the line 21. This illuminates a pattern, part of which is shown in Figure 3D, which has an opaque region 24 corresponding to the bright region 22 in the first pattern and is bright elsewhere, save for dark regions (not shown) covering other structures exposed in the first exposure.

It will be appreciated that it is very convenient to combine this double dipole exposure for isolated lines with double dipole exposures performed to image both horizontal and vertical dense lines with low k1. In that case the process conditions optimum for the dense lines can be used in the two exposures. The immediate vicinity of the isolated lines is exposed in the exposure with the most suitable conditions and the remainder of the open area is exposed in the other exposure.

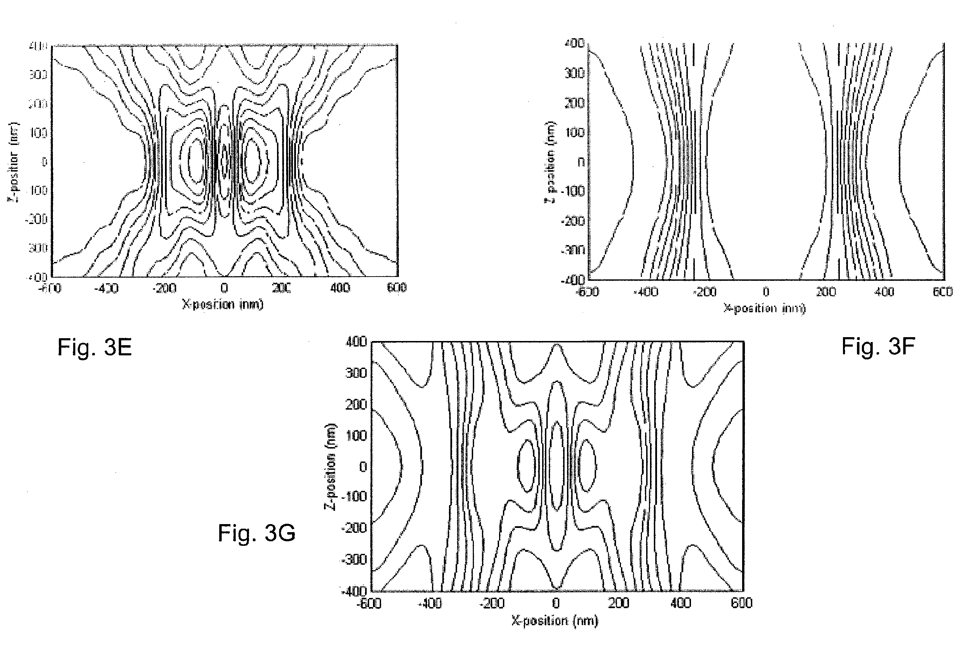

The effects of the first and second exposure are shown in Figures 3E and F respectively, which show the intensity of the aerial image in normalized units as a function of X position and Z (focus). Figure 3G is the sum of Figure 3E and F. It can be seen that the X distribution of the dose delivered is uniform for a wide range of Z values, indicating a large depth of focus.

Whilst specific embodiments of the invention have been described above, it will be appreciated that the invention may be practiced otherwise than as described. The description is not intended to limit the invention.

## Claims

1. A device manufacturing method comprising the steps of:
- providing a substrate that is at least partially covered by a layer of radiation-sensitive material;
- providing a projection beam of radiation using a radiation system;
- performing a first exposure by using patterning means to endow the projection beam with a first pattern in its cross-section, said first pattern including a desired isolated dark feature in a bright local region and being dark around said bright local region; and projecting the patterned beam of radiation onto a target portion of the layer of radiation-sensitive material; and
- performing a second exposure by using patterning means to endow the projection beam with a second pattern in its cross-section, said second pattern being dark in a region substantially corresponding to said bright local region and bright in a wider region around said local region; and projecting the patterned beam of radiation onto a target portion of the layer of radiation-sensitive material;
- wherein said first and second exposures are carried out in either order;
**characterized in that**:
first illumination settings are used in said first exposure and second illumination settings are used in said second exposure, said second illumination settings being different than said first illumination settings.

2. A method according to claim 1 wherein said second illumination settings are arranged so that in the second exposure substantially no radiation enters the dark region corresponding to the local bright region in the first exposure.

3. A method according to claim 1 or 2 wherein said first and second illumination settings differ in illumination mode - *e.g.* circular, annular, dipole, quadrupole, *etc*. - and/or parameters of the illumination mode - *e.g.* NA, σ, σᵢₙₙₑᵣ, σₒᵤₜₑᵣ, orientation of multipole modes, polarization, dose, focus, lens settings, exposure wavelength, etc..

4. A method according to claim 1, 2 or 3 wherein said isolated dark feature is a contact hole and said radiation sensitive material is a negative tone resist.

5. A method according to claim 4 wherein said first and second illumination settings are quadrupole illumination modes with poles on the diagonals but with the poles nearer the optical axis in the second illumination settings.

6. A method according to claim 4 or 5 wherein the first and second illumination settings include numeric aperture of the projection system and the value of the numeric aperture is smaller in the second illumination settings than in the first.

7. A method according to claim 1, 2 or 3 wherein said isolated dark feature is an isolated line.

8. A method according to claim 7 wherein said first illumination settings include a dipole illumination mode with the poles on the axis perpendicular to the isolated line and said second illumination settings include a dipole illumination mode with the poles on the axis parallel to the isolated line.

9. A method according to claim 7 or 8 wherein the half-width of the local region is in the range of from 1.5 to 5 times the target width of the isolated line.

10. A mask set for use in the method of any one of the preceding claims and embodying a first pattern including a desired isolated dark feature in a bright local region; and a second pattern that is dark in a region substantially corresponding to said bright local region and light in a wider region around said local region.

11. A mask set according to claim 10 wherein said mask set comprises a single mask having said first and second patterns embodied in different regions thereof.

12. A mask set according to claim 10 wherein said mask set comprises first and second masks respectively embodying said first and second patterns.

13. A data set for use in the method of any one of claims 1 to 9 and for controlling a programmable patterning means to effect a first pattern including a desired isolated dark feature in a bright local region; and a second pattern that is dark in a region substantially corresponding to said bright local region and light in a wider region around said local region.
